# EUROPEAN PATENT SPECIFICATION

(11) **EP 4 403 937 B1**
(45) Date of publication and mention of the grant of the patent: **29.10.2025**
(21) Application number: 23152288.9
(22) Date of filing: 18.01.2023
(51) Int. Cl.: G01R 31/327, G06N 3/045, H02J 13/00

(54) **SYSTEM FOR MONITORING A SWITCHGEAR**
SYSTEM ZUR ÜBERWACHUNG EINER SCHALTANLAGE
SYSTÈME DE SURVEILLANCE D'UN APPAREILLAGE DE COMMUTATION

(43) Date of publication of application: 24.07.2024
(73) Proprietor: ABB SCHWEIZ AG, 5400 Baden (CH)
(72) Inventor: GITZEL, Ralf, 68165 Mannheim (DE); SCHMIDT, Benedikt, 69117 Heidelberg (DE)
(74) Representative: Maiwald GmbH

(56) References cited:
- US-A1- 2021 397 837
- US-B2- 10 672 153
- US-B2- 8 981 945
- HOU SI-ZU ET AL: "Deep-Learning-Based Fault Type Identification Using Modified CEEMDAN and Image Augmentation in Distribution Power Grid", IEEE SENSORS JOURNAL, IEEE, USA, vol. 22, no. 2, 6 December 2021 (2021-12-06), pages 1583 - 1596, XP011897017, ISSN: 1530-437X, [retrieved on 20220111], DOI: 10.1109/JSEN.2021.3133352

## Description

### FIELD OF THE INVENTION

The present invention relates to a system for monitoring a switchgear, a method for monitoring a switchgear, to a switchgear having such a system, and a computer program element.

### BACKGROUND OF THE INVENTION

Electrical equipment such as switchgear can suffer from small faults that change the electrical resistance of the system. These faults manifest as hot spots and can ultimately lead to catastrophic failures. Here a switchgear can be a high voltage, medium voltage, or low voltage switchgear.

Thus, temperature sensors can be used to determine the state of such equipment (condition monitoring). The most commonly available sensors are thermal point sensors that measure the temperature at a specific position. A network of multiple point sensors can give a good description of the equipment's state.

One solution is to monitor parts of the switchgear, such as the phases, with an infrared thermographic camera to detect the hot spots. This is because infrared (IR) images can be used to identify technical problems within electrical equipment (e.g. switchgear) that lead to the overheating of components and to identify the hot spots themselves. US 8 981 945 B2 monitors the state of a switchgear by processing data from various temperature and current sensors placed at different locations of the switchgear.

Temperature condition monitoring data can be interpretated by defining a temperature threshold for each of the phases of the equipment. If the threshold is exceeded, an alarm is raised.

However, such techniques do not provide early warnings of problems as they develop, and do not provide details on the cause of the problem.

There is a need to address these issues.

### SUMMARY OF THE INVENTION

Therefore, it would be advantageous to have an improved system for monitoring a switchgear.

The object of the present invention is solved with the subject matter of the independent claims, wherein further embodiments are incorporated in the dependent claims. It is to be noted that the system is described with respect to a switchgear, but finds utility in other electrical system than can suffer from components that overheat.

In an aspect, there is provided a system for monitoring a switchgear, the system comprising:
- at least one temperature sensor;
- at least one current sensor;
- a processing unit; and
- an output unit.

The at least one temperature sensor is configured to acquire temperature data for at least one location of a switchgear. The at least one temperature sensor is configured to provide the temperature data to the processing unit. The at least one current sensor is configured to acquire electrical current data for the at least one location of the switchgear. The at least one current sensor is configured to provide the electrical current data to the processing unit. The processing unit is configured to implement a discriminator of a trained conditional generative adversarial network, CGAN. The CGAN comprises a generator and the discriminator. The processing unit is configured to determine a state of the switchgear. The determination of the state of the switchgear comprises utilization of the discriminator without utilization of the generator. The determination of the state of the switchgear comprises utilization of the discriminator to analyze temperature data for one or more locations of the at least one location and electrical current data for the one or more locations. The output unit is configured to output the determined state of the switchgear when the determined state of the switchgear is determined not to be normal or not to be healthy.

The output unit could output detailed information on the output state, however at one level the output could be a simple indication such as a red light being indicated.

Thus a discriminator part of a CGAN is used in a new way to determine if temperature values of a switchgear associated with current values are normal for those current values, enabling an alarm to be raised if the temperature values are not normal.

In this manner, for example temperature values at different locations of one or more phases of a switchgear can be acquired along with the current load of each phase, all of this temperature data or just a single temperature and the associated current load of one phase or singles temperatures and associated current loads for each phase analysed, where those single temperatures could be at locations where the temperature is a maximum. The discriminator can then determine if the temperature or temperatures are normal for the current loads, in which case there is no problem, or if the temperatures are not as expected and it can be determined that an alarm should be raised.

To put this another way, the discriminator algorithm provides information on how probable the currently measured data is for a healthy system. Hot spots will elevate temperature levels such that they are not "normal" for the current situation, and this anomaly can be detected by the discriminator of a CGAN, that could itself be trained only on healthy data that is readily available.

In an example, the determination of the state of the switchgear comprises analyse by the discriminator of the temperature data for the one or more locations and the electrical current data for the one or more locations to determine a probability that the temperature data for the one or more locations is normal or appropriate for the electrical current data for the one or more locations.

In an example, the processing unit is configured to determine that the state of the switchgear is not normal or not healthy when the probability determined by the discriminator is below a threshold value.

In an example, the output unit is configured to output the determined state of the switchgear when the determined state of the switchgear is determined to be normal or to be healthy.

The output unit could output detailed information on the output state, however at one level the output could be a simple indication such as a green light being indicated.

In an example, the determined state of the switchgear comprises an indication that overheating is occurring.

Thus, for a given current it can be determined that overheating that is inappropriate for that current is occurring.

In an example, the at least one temperature sensor comprises one or more infrared cameras, and the temperature data for the at least one location is determined from one or more infrared images.

In an example, the at least one temperature sensor comprises one or more point sensors located at the at least one location, and the temperature data for the at least one location is acquired by the one or more point sensors.

In an example, the one or locations are determined as one or locations with one or more maximum temperatures.

In other words, temperature values at different locations of a phase of a switchgear can be acquired, and all of this data can be analysed along with electrical current data that could just be a single current value for all the temperature values, however only a maximum temperature and the associated current value can be analysed, because this is most likely to be a location where a problem could be occurring, such as hotspot developing due to a loose joint or increased resistance due to another reason such as corrosion or a crack in a busbar for example.

In an example, the temperature data for the at least one location of the switchgear are acquired at the same time or times as the electrical current data for the at least one location of the switchgear.

In an example, the CGAN was trained on a plurality of reference temperature data and reference electrical current data for the at least one location of the switchgear or at least one location of a reference switchgear equivalent to the switchgear.

In an example, the reference temperature data and reference electrical current data are acquired for the switchgear or reference switchgear that is operating without a fault.

Thus, (point) temperature sensors or infrared camera sensor(s) can be used to determine the state of such equipment (condition monitoring). The data generated by the sensors can be used to detect faults. If enough data is available, it can also be used to train a machine learning algorithm to classify examples as faulty and healthy. However, often there is not enough faulty training data to do so. If the equipment rarely shows faults, it is hard to obtain faulty data from the field. Instead, expensive simulations and/or laboratory experiments have to be run. The inventors realised that by using only the discriminator of a CGAN in a new way, the CGAN in terms of the generator and discriminator can be trained with healthy data of a switchgear, which is much more easy to generate than data associated with a switchgear with a fault, and by using just the discriminator it could be determined if temperature data acquired in the field correctly correlates with the current load, and there is no problem, or does not correlate and there is a problem or problem forming.

In an example, the reference temperature data for the at least one location were acquired at the same time or times as the reference electrical current data.

In a second aspect, there is provided a switchgear comprising a system according to the first aspect.

In a second aspect, there is provided a method for monitoring a switchgear, the method comprising:
- acquiring by at least one temperature sensor temperature data for at least one location of a switchgear;
- providing by the at least one temperature sensor the temperature data to a processing unit;
- acquiring by at least one current sensor electrical current data for the at least one location of the switchgear;
- providing by the at least one current sensor the electrical current data to the processing unit;
- implementing by the processing unit is configured a discriminator of a trained conditional generative adversarial network, CGAN, wherein the CGAN comprises a generator and the discriminator;
- determining by the processing unit a state of the switchgear, wherein the determining the state of the switchgear comprises utilizing the discriminator without utilizing the generator, and wherein the determining the state of the switchgear comprises utilizing the discriminator to analyze temperature data for one or more locations of the at least one location and electrical current data for the one or more locations; and
- outputting by an output unit the determined state of the switchgear when the determined state of the switchgear is determined not to be normal or not to be healthy.

According to another aspect, there is provided a computer program element controlling one or more of the systems as previously described which, if the computer program element is executed by a processor, is adapted to perform the methods as previously described.

According to another aspect, there is provided a computer readable medium having stored a computer element as previously described.

The computer program element can for example be a software program but can also be a FPGA, a PLD or any other appropriate digital means.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows a schematic example of a system for monitoring a switchgear;
Fig. 2 shows a schematic example of a method for monitoring a switchgear;
Fig. 3 shows a schematic representation of training of a generator of a conditional generative adversarial network;
Fig. 4 shows a schematic representation of training of a discriminator of a conditional generative adversarial network;
Fig. 5 shows a schematic representation of training of a conditional generative adversarial network; and
Fig. 6 shows a schematic representation of the discriminator of the system for monitoring a switchgear.

### DETAILED DESCRIPTION OF EMBODIMENTS

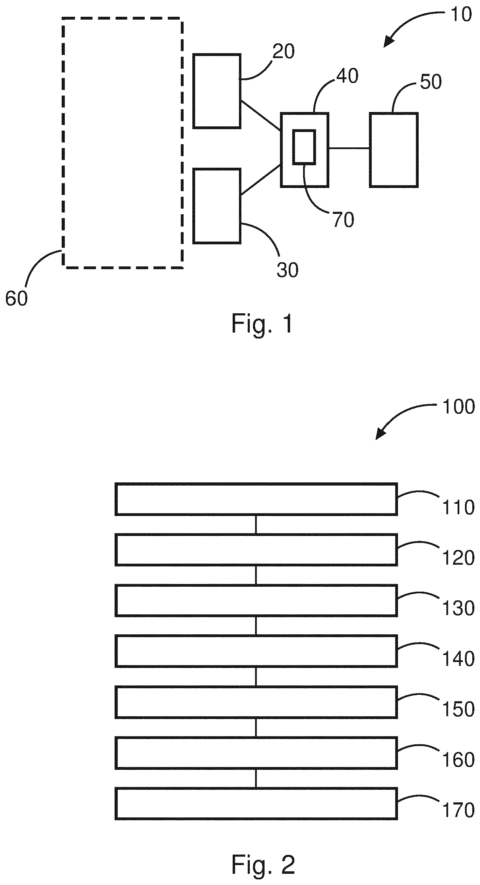

Fig. 1 shows an example of a system 10 for monitoring a switchgear. The system 10 comprises:
- at least one temperature sensor 20;
- at least one current sensor 30;
- a processing unit 40; and
- an output unit 50.

The at least one temperature sensor is configured to acquire temperature data for at least one location of a switchgear 60. The switchgear is shown as a dotted box in Fig. 1 because it is not part of the system as such, where for example the system could be retrofitted to a switchgear or a switchgear could in effect be manufactured with such a system. The at least one temperature sensor is configured to provide the temperature data to the processing unit. The at least one current sensor is configured to acquire electrical current data for the at least one location of the switchgear. The at least one current sensor is configured to provide the electrical current data to the processing unit. The processing unit is configured to implement a discriminator 70 of a trained conditional generative adversarial network, CGAN. The CGAN comprises a generator and the discriminator. The processing unit is configured to determine a state of the switchgear. The determination of the state of the switchgear comprises utilization of the discriminator without utilization of the generator. The determination of the state of the switchgear comprises utilization of the discriminator to analyze temperature data for one or more locations of the at least one location and electrical current data for the one or more locations. The output unit is configured to output the determined state of the switchgear when the determined state of the switchgear is determined not to be normal or not to be healthy. Here not to be healthy is equivalent to not to be normal.

Thus a discriminator part of a CGAN is used in a new way to determine if temperature values of a switchgear associated with current values are normal for those current values, enabling an alarm to be raised if the temperature values are not normal.

Thus, for example temperature values at different locations of one or more phases of a switchgear can be acquired along with the current load of each phase, all of this temperature data or just a single temperature and the associated current load of one phase or singles temperatures and associated current loads for each phase analysed, where those single temperatures could be at locations where the temperature is a maximum. The discriminator can then determine if the temperature or temperatures are normal for the current loads, in which case there is no problem, or if the temperatures are not as expected and it can be determined that an alarm should be raised.

To put this another way, the discriminator algorithm provides information on how probable the currently measured data is for a healthy system. Hot spots will elevate temperature levels such that they are not "normal" for the current situation, and this anomaly can be detected by the discriminator of a CGAN, that could itself be trained only on healthy data that is readily available.

According to an example, the determination of the state of the switchgear comprises analyse by the discriminator of the temperature data for the one or more locations and the electrical current data for the one or more locations to determine a probability that the temperature data for the one or more locations is normal or appropriate for the electrical current data for the one or more locations.

According to an example, the processing unit is configured to determine that the state of the switchgear is not normal or not healthy when the probability determined by the discriminator is below a threshold value.

According to an example, the output unit is configured to output the determined state of the switchgear when the determined state of the switchgear is determined to be normal or to be healthy.

According to an example, the determined state of the switchgear comprises an indication that overheating is occurring.

In an example, the determined state of the switchgear comprises an indication that overheating will occur.

According to an example, the at least one temperature sensor comprises one or more infrared cameras, and the temperature data for the at least one location is determined from one or more infrared images.

According to an example, the at least one temperature sensor comprises one or more point sensors located at the at least one location, and the temperature data for the at least one location is acquired by the one or more point sensors.

According to an example, the one or locations are determined as one or locations with one or more maximum temperatures.

In other words, temperature values at different locations of a phase of a switchgear can be acquired, and all of this data can be analysed along with electrical current data that could just be a single current value for all the temperature values, however only a maximum temperature and the associated current value can be analysed, because this is most likely to be a location where a problem could be occurring, such as hotspot developing due to a loose joint or increased resistance due to another reason such as corrosion or a crack in a busbar for example.

According to an example, the temperature data for the at least one location of the switchgear are acquired at the same time or times as the electrical current data for the at least one location of the switchgear.

According to an example, the CGAN was trained on a plurality of reference temperature data and reference electrical current data for the at least one location of the switchgear or at least one location of a reference switchgear equivalent to the switchgear.

According to an example, the reference temperature data and reference electrical current data are acquired for the switchgear or reference switchgear that is operating without a fault.

Thus, (point) temperature sensors or infrared sensor(s) can be used to determine the state of such equipment (condition monitoring). The data generated by the sensors can be used to detect faults. If enough data is available, it can also be used to train a machine learning algorithm to classify examples as faulty and healthy. However, often there is not enough faulty training data to do so. If the equipment rarely shows faults, it is hard to obtain faulty data from the field. Instead, expensive simulations and/or laboratory experiments have to be run. The inventors realised that by using only the discriminator of a CGAN in a new way, the CGAN in terms of the generator and discriminator can ne trained with healthy data of a switchgear, which is much more easy to generate than data associated with a switchgear with a fault, and by using just the discriminator it could be determined if temperature data acquired in the field correctly correlates with the current load, and there is no problem, or does not correlate and there is a problem or problem forming.

According to an example, the reference temperature data for the at least one location were acquired at the same time or times as the reference electrical current data.

It is clear from the above that a switchgear 60 can comprise a system 10 as described with respect to Fig. 1.

Fig. 2 shows a method 100 for monitoring a switchgear. The method 100 comprises:
- acquiring 110 by at least one temperature sensor temperature data for at least one location of a switchgear;
- providing 120 by the at least one temperature sensor the temperature data to a processing unit;
- acquiring 130 by at least one current sensor electrical current data for the at least one location of the switchgear;
- providing 140 by the at least one current sensor the electrical current data to the processing unit;
- implementing 150 by the processing unit is configured a discriminator of a trained conditional generative adversarial network, CGAN, wherein the CGAN comprises a generator and the discriminator;
- determining 160 by the processing unit a state of the switchgear, wherein the determining the state of the switchgear comprises utilizing the discriminator without utilizing the generator, and wherein the determining the state of the switchgear comprises utilizing the discriminator to analyze temperature data for one or more locations of the at least one location and electrical current data for the one or more locations; and
- outputting 170 by an output unit the determined state of the switchgear when the determined state of the switchgear is determined not to be normal or not to be healthy.

In an example, the determining the state of the switchgear comprises analyse by the discriminator of the temperature data for the one or more locations and the electrical current data for the one or more locations to determine a probability that the temperature data for the one or more locations is normal or appropriate for the electrical current data for the one or more locations.

In an example, the method comprises determining by processing unit that the state of the switchgear is not normal or not healthy when the probability determined by the discriminator is below a threshold value.

In an example, the method comprises outputting by the output unit the determined state of the switchgear when the determined state of the switchgear is determined to be normal or to be healthy.

In an example, the determined state of the switchgear comprises an indication that overheating is occurring.

In an example, the determined state of the switchgear comprises an indication that overheating will occur.

In an example, the at least one temperature sensor comprises one or more infrared cameras, and wherein the temperature data for the at least one location is determined from one or more infrared images.

In an example, the at least one temperature sensor comprises one or more point sensors located at the at least one location, and wherein the temperature data for the at least one location is acquired by the one or more point sensors.

In an example, the one or more point sensors are thermocouples.

In an example, the one or locations are determined as one or locations with one or more maximum temperatures.

In an example, the temperature data for the at least one location of the switchgear are acquired at the same time or times as the electrical current data for the at least one location of the switchgear.

In an example, the CGAN was trained on a plurality of reference temperature data and reference electrical current data for the at least one location of the switchgear or at least one location of a reference switchgear equivalent to the switchgear.

In an example, the reference temperature data and reference electrical current data are acquired for the switchgear or reference switchgear that is operating without a fault.

In an example, the reference temperature data for the at least one location were acquired at the same time or times as the reference electrical current data.

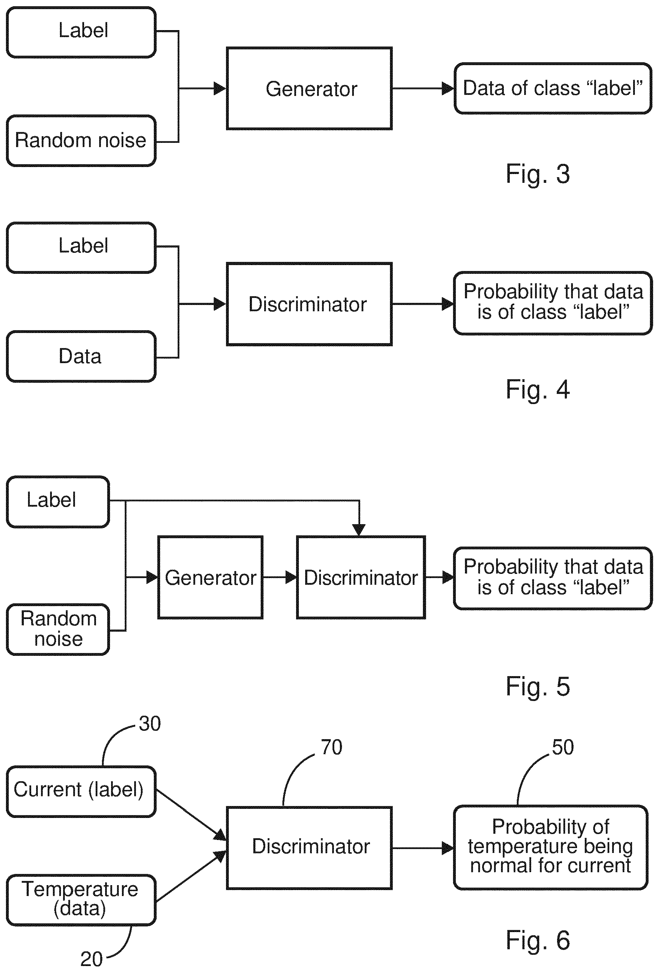

The system and method for monitoring a switchgear is described in further detail, with respect to specific embodiments, where reference is made to Figs. 3-6.

Before describing the discriminator 70, that is part of a conditional generative adversarial network (CGAN), where only the discriminator 70 is used in the newly developed system 10 and method 100, here follows a brief discussion of a CGAN and the generator and discriminator parts thereof.

Generally, a CGAN consists of a generator and a discriminator. The generator part can be trained to produce deceptively realistic data for a specific class label. For example, the generator part can be used to produce things like realistic-looking photos or images of things or people that do not exist.

Fig. 3 shows such a generator of a CGAN.

The generator however needs to be trained to produce realistic data. For this purpose, a discriminator is used. Taking an example, where a generator generates an image based on a class, the discriminator is able to determine whether the image is realistic for the class or not.

Fig. 4 shows such a discriminator of a CGAN.

For the purpose of training the generator, the (frozen) discriminator is attached to the output of the generator, as shown in Fig. 5. The loss of the joint model is minimized to get realistic looking output data.

Normally, after training the CGAN the discriminator is discarded after training, and only the generator is used.

However, the inventors realized that a CGAN in terms of a generator and discriminator could be trained using readily available data for a switchgear, and then the discriminator is used alone to determine if the switchgear has a problem.

Fig. 6 shows the key parts of the new system 10 in terms of electrical current data (that can be termed labels in the vernacular of CGAN training), acquired for example by current sensors 30, and temperature data, acquired for example by temperature sensors 20. This data is provided to the trained discriminator 70 that is run on a processing unit 40. The probability of the temperature being normal for the current is then output on an output unit 50.

Thus, referring to Fig. 5 with respect to the new technique the discriminator can be considered to be the discriminator 70 with respect to training of the discriminator. The CGAN is then trained to take a label that describes the level of electrical current and generate temperature values that are realistic for that input. If enough data is available the label is a rounded float value in Ampere or a more qualitative label such as "high"/"medium"/"low" if not. It is however to be noted that the CGAN is only trained on healthy data. Eventually, the generator can be trained to generate values that would fool even a trained human observer.

More importantly, the discriminator 70 can judge whether temperature values correspond to a given current load for a healthy situation.

The discriminator 70 is then used without the generator, as shown in Fig, 1 and Fig. 6, on real-world data. Its output value can be interpreted as the probability of the measured temperature being "appropriate" for the given electrical current. If the probability is low, there is some kind of anomaly such as a fault in the system that produces a hot spot.

In another exemplary embodiment, a computer program or computer program element is provided that is characterized by being configured to execute the method steps of the method according to one of the preceding embodiments, on an appropriate processor or system.

The computer program element might therefore be stored on a computer unit, which might also be part of an embodiment. This computing unit may be configured to perform or induce performing of the steps of the method described above. Moreover, it may be configured to operate the components of the above described system. The computing unit can be configured to operate automatically and/or to execute the orders of a user. A computer program may be loaded into a working memory of a data processor. The data processor may thus be equipped to carry out the method according to one of the preceding embodiments.

This exemplary embodiment of the invention covers both, a computer program that right from the beginning uses the invention and computer program that by means of an update turns an existing program into a program that uses the invention.

Further on, the computer program element might be able to provide all necessary steps to fulfill the procedure of an exemplary embodiment of the method as described above.

According to a further exemplary embodiment of the present invention, a computer readable medium, such as a CD-ROM, USB stick or the like, is presented wherein the computer readable medium has a computer program element stored on it which computer program element is described by the preceding section.

A computer program may be stored and/or distributed on a suitable medium, such as an optical storage medium or a solid state medium supplied together with or as part of other hardware, but may also be distributed in other forms, such as via the internet or other wired or wireless telecommunication systems.

However, the computer program may also be presented over a network like the World Wide Web and can be downloaded into the working memory of a data processor from such a network. According to a further exemplary embodiment of the present invention, a medium for making a computer program element available for downloading is provided, which computer program element is arranged to perform a method according to one of the previously described embodiments of the invention.

## Claims

1. A system (10) for monitoring a switchgear, the system comprising:
- at least one temperature sensor (20);
- at least one current sensor (30);
- a processing unit (40); and
- an output unit (50);
wherein the at least one temperature sensor is configured to acquire temperature data for at least one location of a switchgear (60);
wherein the at least one temperature sensor is configured to provide the temperature data to the processing unit;
wherein the at least one current sensor is configured to acquire electrical current data for the at least one location of the switchgear;
wherein the at least one current sensor is configured to provide the electrical current data to the processing unit;
**characterised in that** the processing unit is configured to implement a discriminator (70) of a trained conditional generative adversarial network, CGAN, wherein the CGAN comprises a generator and the discriminator;
wherein the processing unit is configured to determine a state of the switchgear, wherein the determination of the state of the switchgear comprises utilization of the discriminator without utilization of the generator, and wherein the determination of the state of the switchgear comprises utilization of the discriminator to analyze temperature data for one or more locations of the at least one location and electrical current data for the one or more locations; and
wherein the output unit is configured to output the determined state of the switchgear when the determined state of the switchgear is determined not to be normal or not to be healthy.

2. System according to claim 1, wherein the determination of the state of the switchgear comprises analyze by the discriminator of the temperature data for the one or more locations and the electrical current data for the one or more locations to determine a probability that the temperature data for the one or more locations is normal or appropriate for the electrical current data for the one or more locations.

3. System according to claim 2, wherein the processing unit is configured to determine that the state of the switchgear is not normal or not healthy when the probability determined by the discriminator is below a threshold value.

4. System according to any of claims 1-3, wherein the output unit is configured to output the determined state of the switchgear when the determined state of the switchgear is determined to be normal or to be healthy.

5. System according to any of claims 1-4, wherein the determined state of the switchgear comprises an indication that overheating is occurring.

6. System according to any of claims 1-5, wherein the at least one temperature sensor comprises one or more infrared cameras, and wherein the temperature data for the at least one location is determined from one or more infrared images.

7. System according to any of claims 1-5, wherein the at least one temperature sensor comprises one or more point sensors located at the at least one location, and wherein the temperature data for the at least one location is acquired by the one or more point sensors.

8. System according to any of claims 1-7, wherein the one or locations are determined as one or locations with one or more maximum temperatures.

9. System according to any of claims 1-8, wherein the temperature data for the at least one location of the switchgear are acquired at the same time or times as the electrical current data for the at least one location of the switchgear.

10. System according to any of claims 1-9, wherein the CGAN was trained on a plurality of reference temperature data and reference electrical current data for the at least one location of the switchgear or at least one location of a reference switchgear equivalent to the switchgear.

11. System according to claim 10, wherein the reference temperature data and reference electrical current data are acquired for the switchgear or reference switchgear that is operating without a fault.

12. System according to any of claims 10-11, wherein the reference temperature data for the at least one location were acquired at the same time or times as the reference electrical current data.

13. A switchgear (60) comprising a system (10) according to any of claims 1-12.

14. A method (100) for monitoring a switchgear, the method comprising:
- acquiring (110) by at least one temperature sensor temperature data for at least one location of a switchgear;
- providing (120) by the at least one temperature sensor the temperature data to a processing unit;
- acquiring (130) by at least one current sensor electrical current data for the at least one location of the switchgear;
- providing (140) by the at least one current sensor the electrical current data to the processing unit; the method **characterised by**
- implementing (150) by the processing unit a discriminator of a trained conditional generative adversarial network, CGAN, wherein the CGAN comprises a generator and the discriminator;
- determining (160) by the processing unit a state of the switchgear, wherein the determining the state of the switchgear comprises utilizing the discriminator without utilizing the generator, and wherein the determining the state of the switchgear comprises utilizing the discriminator to analyze temperature data for one or more locations of the at least one location and electrical current data for the one or more locations; and
- outputting (170) by an output unit the determined state of the switchgear when the determined state of the switchgear is determined not to be normal or not to be healthy.

15. A computer program element for controlling a system according to any of claims 1-12 which when executed by the processing unit (40) thereof is configured to carry out the method of claim 14.

## Patentansprüche

1. System (10) zur Überwachung einer Schaltanlage, wobei das System umfasst:
- mindestens einen Temperatursensor (20);
- mindestens einen Stromsensor (30);
- eine Verarbeitungseinheit (40); und
- eine Ausgabeeinheit (50);
wobei der mindestens eine Temperatursensor derart eingerichtet ist, dass er Temperaturdaten für mindestens eine Stelle eines Schaltgeräts (60) erfasst;
wobei der mindestens eine Temperatursensor derart eingerichtet ist, dass er die Temperaturdaten an die Verarbeitungseinheit liefert;
wobei der mindestens eine Stromsensor derart eingerichtet ist, dass er elektrische Stromdaten für den mindestens einen Standort der Schaltanlage erfasst;
wobei der mindestens eine Stromsensor derart eingerichtet ist, dass er die elektrischen Stromdaten an die Verarbeitungseinheit liefert;
**dadurch gekennzeichnet, dass** die Verarbeitungseinheit derart eingerichtet ist, dass sie einen Diskriminator (70) eines trainierten bedingten generativen gegnerischen Netzwerks (CGAN) implementiert, wobei das CGAN einen Generator und den Diskriminator umfasst;
wobei die Verarbeitungseinheit derart eingerichtet ist, dass sie einen Zustand der Schaltanlage bestimmt, wobei die Bestimmung des Zustands der Schaltanlage die Verwendung des Diskriminators ohne Verwendung des Generators umfasst, und wobei die Bestimmung des Zustands der Schaltanlage die Verwendung des Diskriminators umfasst, um Temperaturdaten für einen oder mehrere Standorte des mindestens einen Standorts und Stromdaten für den einen oder die mehreren Standorte zu analysieren; und
wobei die Ausgabeeinheit derart eingerichtet ist, dass sie den ermittelten Zustand der Schaltanlage ausgibt, wenn festgestellt wird, dass der ermittelte Zustand der Schaltanlage nicht normal oder nicht gesund ist.

2. System nach Anspruch 1, wobei die Bestimmung des Zustands der Schaltanlage eine Analyse der Temperaturdaten für den einen oder die mehreren Standorte und der Stromdaten für den einen oder die mehreren Standorte durch den Diskriminator umfasst, um eine Wahrscheinlichkeit zu bestimmen, dass die Temperaturdaten für den einen oder die mehreren Standorte normal oder für die Stromdaten für den einen oder die mehreren Standorte angemessen sind.

3. System nach Anspruch 2, wobei die Verarbeitungseinheit derart eingerichtet ist, dass sie feststellt, dass der Zustand der Schaltanlage nicht normal oder nicht gesund ist, wenn die durch den Diskriminator bestimmte Wahrscheinlichkeit unter einem Schwellenwert liegt.

4. System nach einem der Ansprüche 1 bis 3, wobei die Ausgabeeinheit derart eingerichtet ist, dass sie den ermittelten Zustand der Schaltanlage ausgibt, wenn der ermittelte Zustand der Schaltanlage als normal oder als gesund ermittelt wird.

5. System nach einem der Ansprüche 1-4, wobei der ermittelte Zustand der Schaltanlage einen Hinweis auf eine Überhitzung umfasst.

6. System nach einem der Ansprüche 1-5, wobei der mindestens eine Temperatursensor eine oder mehrere Infrarotkameras umfasst und wobei die Temperaturdaten für den mindestens einen Standort aus einem oder mehreren Infrarotbildern bestimmt werden.

7. System nach einem der Ansprüche 1-5, wobei der mindestens eine Temperatursensor einen oder mehrere Punktsensoren umfasst, die sich an dem mindestens einen Standort befinden, und wobei die Temperaturdaten für den mindestens einen Standort von dem einen oder den mehreren Punktsensoren erfasst werden.

8. System nach einem der Ansprüche 1-7, wobei der eine oder die Standorte als ein oder mehrere Standorte mit einer oder mehreren Maximaltemperaturen bestimmt werden.

9. System nach einem der Ansprüche 1-8, wobei die Temperaturdaten für den mindestens einen Standort der Schaltanlage unter zur gleichen Zeit oder zu den gleichen Zeiten wie die elektrischen Stromdaten für den mindestens einen Standort der Schaltanlage erfasst werden.

10. System nach einem der Ansprüche 1 bis 9, wobei das CGAN anhand einer Vielzahl von Referenztemperaturdaten und Referenzstromdaten für den mindestens einen Standort der Schaltanlage oder mindestens einen Standort einer der Schaltanlage gleichwertigen Referenzschaltanlage trainiert wurde.

11. System nach Anspruch 10, wobei die Referenztemperaturdaten und die elektrischen Referenzstromdaten für die Schaltanlage oder die Referenzschaltanlage erfasst werden, die ohne Fehler betrieben wird.

12. System nach einem der Ansprüche 10 bis 11, wobei die Referenztemperaturdaten für den mindestens einen Standort zur gleichen Zeit oder zu den gleichen Zeiten wie die elektrischen Referenzstromdaten erfasst wurden.

13. Schaltanlage (60) mit einem System (10) nach einem der Ansprüche 1-12.

14. Verfahren (100) zur Überwachung einer Schaltanlage, wobei das Verfahren umfasst:
- Erfassen (110) von Temperaturdaten für mindestens eine Stelle einer Schaltanlage durch mindestens einen Temperatursensor;
- Bereitstellen (120) der Temperaturdaten durch den mindestens einen Temperatursensor an eine Verarbeitungseinheit;
- Erfassen (130) von elektrischen Stromdaten für den mindestens einen Standort der Schaltanlage durch mindestens einen Stromsensor;
- Bereitstellung (140) der elektrischen Stromdaten durch den mindestens einen Stromsensor an die Verarbeitungseinheit;
wobei das Verfahren **gekennzeichnet ist durch**
- das Implementieren (150) eines Diskriminators eines trainierten bedingten generativen adversen Netzwerks, CGAN, durch die Verarbeitungseinheit konfiguriert wird, wobei das CGAN einen Generator und den Diskriminator umfasst;
- Bestimmen (160) eines Zustands der Schaltanlage durch die Verarbeitungseinheit, wobei das Bestimmen des Zustands der Schaltanlage die Verwendung des Diskriminators ohne Verwendung des Generators umfasst, und wobei das Bestimmen des Zustands der Schaltanlage die Verwendung des Diskriminators zum Analysieren von Temperaturdaten für einen oder mehrere Standorte des mindestens einen Standortes und von elektrischen Stromdaten für den einen oder die mehreren Standorte umfasst; und
- Ausgeben (170) des ermittelten Zustands der Schaltanlage durch eine Ausgabeeinheit, wenn der ermittelte Zustand der Schaltanlage als nicht normal oder als nicht gesund ermittelt wird.

15. Computerprogrammelement zur Steuerung eines Systems nach einem der Ansprüche 1 bis 12, das bei Ausführung durch seine Verarbeitungseinheit (40) derart eingerichtet ist, dass es das Verfahren nach Anspruch 14 durchführt.

## Revendications

1. Système (10) de surveillance d'un appareillage de commutation, le système comprenant :
- au moins un capteur de température (20) ;
- au moins un capteur de courant (30) ;
- une unité de traitement (40) ; et
- une unité de sortie (50) ;
l'au moins un capteur de température étant configuré pour acquérir des données de température pour au moins un endroit d'un appareillage de commutation (60) ;
l'au moins un capteur de température étant configuré pour fournir les données de température à l'unité de traitement ;
l'au moins un capteur de courant étant configuré pour acquérir des données de courant électrique pour l'au moins un endroit de l'appareillage de commutation ;
l'au moins un capteur de courant étant configuré pour fournir les données de courant électrique à l'unité de traitement ;
**caractérisé en ce que**
l'unité de traitement est configurée pour mettre en œuvre un discriminateur (70) d'un réseau antagoniste génératif conditionnel, CGAN, entraîné, le CGAN comprenant un générateur et le discriminateur ;
l'unité de traitement étant configurée pour déterminer un état de l'appareillage de commutation, la détermination de l'état de l'appareillage de commutation comprenant l'utilisation du discriminateur sans utilisation du générateur, et la détermination de l'état de l'appareillage de commutation comprenant l'utilisation du discriminateur pour analyser des données de température pour un ou plusieurs endroits de l'au moins un endroit et des données de courant électrique pour le ou les endroits ; et
l'unité de sortie étant configurée pour délivrer l'état déterminé de l'appareillage de commutation en cas de détermination que l'état déterminé de l'appareillage de commutation est anormal ou non sain.

2. Système selon la revendication **1,** dans lequel la détermination de l'état de l'appareillage de commutation comprend l'analyse, par le discriminateur, des données de température pour le ou les endroits et des données de courant électrique pour le ou les endroits afin de déterminer une probabilité que les données de température pour le ou les endroits soient normales ou appropriées pour les données de courant électrique pour le ou les endroits.

3. Système selon la revendication 2, dans lequel l'unité de traitement est configurée pour déterminer que l'état de l'appareillage de commutation est anormal ou non sain lorsque la probabilité déterminée par le discriminateur est inférieure à une valeur seuil.

4. Système selon l'une quelconque des revendications 1 à 3, dans lequel l'unité de sortie est configurée pour délivrer l'état déterminé de l'appareillage de commutation en cas de détermination que l'état déterminé de l'appareillage de commutation est normal ou sain.

5. Système selon l'une quelconque des revendications 1 à 4, dans lequel l'état déterminé de l'appareillage de commutation comprend une indication de la présence d'une surchauffe.

6. Système selon l'une quelconque des revendications 1 à 5, dans lequel l'au moins un capteur de température comprend une ou plusieurs caméras infrarouges, et dans lequel les données de température pour l'au moins un endroit sont déterminées à partir d'une ou de plusieurs images infrarouges.

7. Système selon l'une quelconque des revendications 1 à 5, dans lequel l'au moins un capteur de température comprend un ou plusieurs capteurs ponctuels situés à l'au moins un endroit, et dans lequel les données de température pour l'au moins un endroit sont acquises par le ou les capteurs ponctuels.

8. Système selon l'une quelconque des revendications 1 à 7, dans lequel le ou les endroits sont déterminés comme un ou des endroits présentant une ou plusieurs températures maximales.

9. Système selon l'une quelconque des revendications 1 à 8, dans lequel les données de température pour l'au moins un endroit de l'appareillage de commutation sont acquises simultanément ou aux mêmes moments que les données de courant électrique pour l'au moins un endroit de l'appareillage de commutation.

10. Système selon l'une quelconque des revendications 1 à 9, dans lequel le CGAN a été entraîné sur une pluralité de données de température de référence et de données de courant électrique de référence pour l'au moins un endroit de l'appareillage de commutation ou au moins un endroit d'un appareillage de commutation de référence équivalent à l'appareillage de commutation.

11. Système selon la revendication 10, dans lequel les données de température de référence et les données de courant électrique de référence sont acquises pour l'appareillage de commutation ou l'appareillage de commutation de référence fonctionnant sans défaut.

12. Système selon l'une quelconque des revendications 10 à 11, dans lequel les données de température de référence pour l'au moins un endroit ont été acquises simultanément ou aux mêmes moments que les données de courant électrique de référence.

13. Appareillage de commutation (60) comprenant un système (10) selon l'une quelconque des revendications 1 à 12.

14. Procédé (100) de surveillance d'un appareillage de commutation, le procédé comprenant :
- l'acquisition (110), par au moins un capteur de température, de données de température pour au moins un endroit d'un appareillage de commutation ;
- la fourniture (120), par l'au moins un capteur de température, des données de température à une unité de traitement ;
- l'acquisition (130), par au moins un capteur de courant, de données de courant électrique pour l'au moins un endroit de l'appareillage de commutation ;
- la fourniture (140), par l'au moins un capteur de courant, des données de courant électrique à l'unité de traitement ; le procédé étant **caractérisé par**
- la mise en œuvre (150), par l'unité de traitement, d'un discriminateur d'un réseau antagoniste génératif conditionnel, CGAN, entraîné, le CGAN comprenant un générateur et le discriminateur ;
- la détermination (160), par l'unité de traitement, d'un état de l'appareillage de commutation, la détermination de l'état de l'appareillage de commutation comprenant l'utilisation du discriminateur sans utilisation du générateur, et la détermination de l'état de l'appareillage de commutation comprenant l'utilisation du discriminateur pour analyser des données de température pour un ou plusieurs endroits de l'au moins un endroit et des données de courant électrique pour le ou les endroits ; et
- la délivrance (170), par une unité de sortie, de l'état déterminé de l'appareillage de commutation en cas de détermination que l'état déterminé de l'appareillage de commutation est anormal ou non sain.

15. Élément de programme d'ordinateur destiné à commander un système selon l'une quelconque des revendications 1 à 12, qui, lorsqu'il est exécuté par l'unité de traitement (40) de ce système, est configuré pour réaliser le procédé selon la revendication 14.
